# EUROPEAN PATENT APPLICATION

(11) **EP 4 768 933 A1**
(43) Date of publication of application: **01.07.2026**
(21) Application number: 24900959.8
(22) Date of filing: 27.11.2024
(51) Int. Cl.: G01R 31/367, G01R 31/382, G01R 19/00, G01R 31/371, G06F 17/18, G06N 3/09, H01M 10/052

(54) **BATTERY MANAGEMENT DEVICE AND BATTERY MANAGEMENT METHOD**

(30) Priority: 05.12.2023 KR 20230174556
(71) Applicant: LG Energy Solution, Ltd., Seoul 07335 (KR)
(72) Inventor: YIM, In Hyeok, Daejeon 34122 (KR); KIM, Young Jin, Daejeon 34122 (KR); LEE, Beak San, Daejeon 34122 (KR); CHOI, Jee Soon, Daejeon 34122 (KR); PARK, Jhin Ha, Daejeon 34122 (KR); KIM, Min Young, Daejeon 34122 (KR); BYEON, Min Jeong, Daejeon 34122 (KR)
(74) Representative: Plasseraud IP
(86) International application number: PCT/KR2024/018992
(87) International publication number: WO 2025/121773

(57) **Abstract**

A battery management apparatus disclosed herein includes a communication unit configured to receive battery data of a battery cell and a control unit configured to derive a voltage average for each of a plurality of sections included in the battery data, input some of voltage averages for the plurality of sections to a training model based on self-supervised learning, and detect whether the battery cell is defective by using voltage prediction values output by the training model.

## Description

### Technical Field

### CROSS-REFERENCE TO RELATED APPLICATION

This application claims priority to and the benefit of Korean Patent Application No. 10-2023-0174556 filed in the Korean Intellectual Property Office on December 5, 2023, the entire content of which is incorporated herein by reference.

### TECHNICAL FIELD

Embodiments disclosed herein relate to a battery management apparatus and a battery management method for diagnosing a state of a battery.

### Background Art

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices. In addition, the lithium-ion battery is attracting attention as a next-generation energy storage medium as a usage range thereof is expanded to a power source of electric vehicles.

As the occurrence of defective battery cells, such as tab disconnection or lithium precipitation, in the battery may cause safety issues during battery use, research is being conducted on a defective battery cell detection algorithm. Generally, when a machine learning method is applied to battery safety diagnosis, supervised learning using a voltage value of a battery cell as an input value and defective battery information as an output value may be used. However, supervised learning may have unsatisfactory accuracy of learning performance and result values due to insufficient data regarding the defective battery information.

### Disclosure

### Technical Problem

An embodiment disclosed herein provides a battery management apparatus and a battery management method in which a battery is diagnosed based on a battery safety diagnostic indicator derived using self-supervised learning.

Technical problems of the embodiments disclosed herein are not limited to the above-described technical problems, and other unmentioned technical problems would be clearly understood by one of ordinary skill in the art from the following description.

### Technical Solution

A battery management apparatus according to an embodiment includes a communication unit configured to receive battery data of a battery cell and a control unit configured to derive a voltage average for each of a plurality of sections included in the battery data, input some of voltage averages for the plurality of sections to a training model based on self-supervised learning, and detect whether the battery cell is defective by using voltage prediction values output by the training model.

The control unit may be further configured to determine, as the voltage average, an average of each section in which a voltage is maintained constant in a charging/discharging profile of the battery cell.

The training model may include a plurality of linear regression models including voltage averages remaining after excluding some from the voltage averages.

The control unit may be further configured to derive a plurality of output values by inputting some of the voltage averages to the plurality of linear regression models.

The control unit may be further configured to determine, as an error for each of the plurality of sections, a difference between the voltage prediction values that are the plurality of output values and an actual value that is a part of the voltage averages.

The control unit may be further configured to determine a diagnostic indicator of the battery cell by summing errors for the plurality of sections.

The control unit may be further configured to determine the battery cell as being defective based on that the diagnostic indicator exceeds a preset diagnosis criterion.

The training model based on self-supervised learning may include a linear mixed model (LMM) to detect whether the battery cell is defective.

A battery management method according to an embodiment includes receiving battery data of a battery cell, deriving voltage averages for a plurality of sections included in the battery data, inputting some of the voltage averages for the plurality of sections to a training model based on self-supervised learning, and detecting whether the battery cell is defective by using voltage prediction values output by the training model.

The deriving of the voltage averages may include deriving, as the voltage average, an average of each section in which a voltage is maintained constant in a charging/discharging profile of the battery cell.

The training model may include a plurality of linear regression models including voltage averages remaining after excluding some from the voltage averages.

The battery management method may further include deriving a plurality of output values by inputting some of the voltage averages to the plurality of linear regression models.

The battery management method may further include determining, as an error for each of the plurality of sections, a difference between the voltage prediction values that are the plurality of output values and an actual value that is a part of the voltage averages.

The battery management method may further include determining a diagnostic indicator of the battery cell by summing errors for the plurality of sections.

The detecting of whether the battery cell is defective may include determining the battery cell as being defective based on that the diagnostic indicator exceeds a preset diagnosis criterion.

The training model based on self-supervised learning may include a linear mixed model (LMM) to detect whether the battery cell is defective.

### Advantageous Effects

With a battery management apparatus according to an embodiment, as a defect of a battery may be detected based on self-supervised learning, a machine learning model may be trained even when labelled defective battery information is insufficient.

With the battery management apparatus according to an embodiment, a diagnosis algorithm having high general utility due to applicability to any battery data may be provided.

### Description of Drawings

FIG. 1 is a block diagram showing a configuration of a general battery system including a battery management apparatus according to an embodiment.
FIG. 2 is a block diagram showing a configuration of a battery management apparatus according to an embodiment.
FIG. 3 shows an input value and an output value of a machine learning model used in a battery management apparatus according to an embodiment.
FIG. 4 is a schematic flowchart for a battery management apparatus according to an embodiment to detect a defective battery.
FIG. 5 shows a voltage average derived by a battery management apparatus according to an embodiment.
FIG. 6 shows a correlation between a normal battery cell and a defective battery cell, derived by a battery management apparatus according to an embodiment.
FIG. 7 is a graph showing a diagnostic indicator derived by a battery management apparatus according to an embodiment.
FIG. 8 shows a voltage prediction value and an actual value, derived from one battery pack, by a battery management apparatus according to an embodiment.
FIG. 9 shows an error derived from one battery pack by a battery management apparatus according to an embodiment.
FIG. 10 is a control flowchart of a battery management method according to an embodiment.

### Mode for Invention

Hereinafter, various embodiments disclosed herein will be described in detail with reference to the accompanying drawings. In this document, identical reference numerals will be used for identical components in the drawings, and the identical components will not be redundantly described.

For various embodiments disclosed herein, specific structural or functional descriptions are only exemplified for the purpose of describing the embodiments, and various embodiments disclosed herein may be implemented in various forms, and should not be construed as being limited to the embodiments described herein.

As used in various embodiments, the terms "1^{st}, "2^{nd}", "first", "second", or the like may modify various components regardless of importance, and do not limit the components. For example, a first component may be named as a second component without departing from the right scope of an embodiment disclosed herein, and similarly, the second component may be named as the first component.

Terms used herein are used for only describing a specific exemplary embodiment and may not have an intention to limit the scope of other exemplary embodiments. It is to be understood that the singular forms include plural references unless the context clearly dictates otherwise.

All terms including technical or scientific terms used herein have the same meaning as commonly understood by those of ordinary skill in the art to which the embodiments disclosed herein belong. It will be further understood that terms, such as those defined in commonly used dictionaries, should be interpreted as having a meaning that is identical to or similar with their meaning in the context of the relevant art and will not be interpreted in an idealized or overly formal sense unless expressly so defined herein. In some cases, the terms defined herein may be interpreted to exclude embodiments disclosed herein.

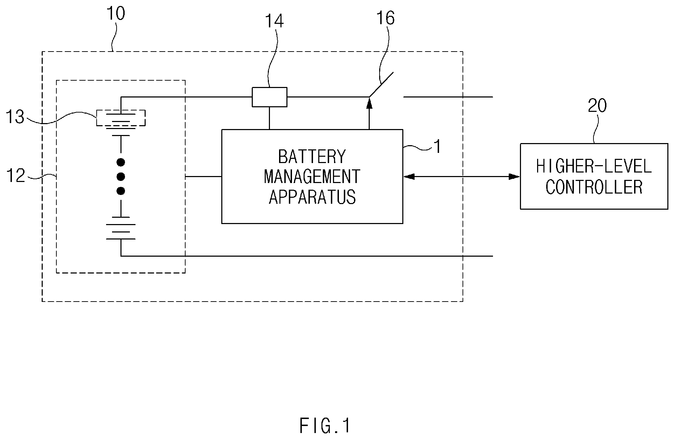

FIG. 1 is a block diagram showing a configuration of a general battery system including a battery management apparatus according to various embodiments.

Specifically, FIG. 1 schematically shows a battery system 10 and a higher-level controller 20 included in a higher-level system according to an embodiment disclosed herein.

As shown in FIG. 1, the battery system 10 may include a plurality of battery modules 12, a sensor unit 14, a switching unit 16, and a battery management apparatus 1. The battery system 10 may include the battery module 12, the sensor unit 14, the switching unit 16, and the battery management apparatus 1 provided in plural.

The plurality of battery modules 12 may include at least one chargeable/dischargeable battery cells 13. The battery cell 13 may include a positive electrode, a positive electrode material, a negative electrode, a negative electrode material, a separator, polymer, and a case. In this case, the plurality of battery modules 12 may be connected in series or in parallel.

The sensor unit 14 may include a voltage sensor 2, a current sensor 3, and a temperature sensor (not shown).

The voltage sensor 2 may be connected in parallel with the battery and configured to detect a battery voltage across opposite ends of the battery and generate a voltage signal indicating the detected battery voltage.

The current sensor 3 may detect a current used in a process of determining a state of charge (SOC) of the battery cell 13.

The current sensor 3 may include any component for generating a signal corresponding to a magnitude of a charging current, and may be installed on a charging/discharging path in which the charging/discharging current flows in a battery.

The current sensor 3 may measure a battery current flowing in the battery, i.e., a charging current and a discharging current, and transmit a measurement result to the battery management apparatus 1. According to an embodiment, the current sensor 3 may measure the battery current at predetermined intervals and transmit a measurement result to the battery management apparatus 1, in a charging cycle for charging the battery with power of an external device or a discharging cycle for discharging the battery.

The temperature sensor may be configured to measure a battery temperature and generate a temperature signal indicating the measured battery temperature. The temperature sensor may be arranged in a case to measure a temperature close to an actual temperature of the battery. For example, the temperature sensor may be attached to a surface of at least one battery cell included in a cell group and detect the surface temperature of the battery cell as the battery temperature.

The temperature sensor may be configured to measure an external temperature that is a temperature at a predetermined position spaced apart from the battery and generate the temperature signal indicating the measured external temperature. The temperature sensor may be arranged at a predetermined position outside the case in which heat exchange is made between the battery and the atmosphere. According to an embodiment, the temperature sensor may be implemented in combination of one or two or more of known temperature detection elements such as a thermocouple, a thermistor, a bimetal, etc. The current sensor may detect current flowing in the battery system 10. In this case, a detection signal may be transmitted to the battery management apparatus 1.

While the sensor unit 14 is connected between the positive electrode of the battery cell 13 and the switching unit 16 in FIG. 1, the sensor unit 14 may also be positioned on a printed circuit board (PCB) provided around the battery cell 13, and the components shown in FIG. 1 and connection relationships therebetween are examples and the present disclosure is not limited thereto.

The switching unit 16 may be serially connected to a positive (+) terminal side or a negative (-) terminal side of the battery module 12 to control a charging/discharging current flow of the battery module 12. For example, for the switching unit 16, at least one relay, a magnetic contactor, etc., may be used, depending on the specification of the battery system 10.

The battery management apparatus 1 may perform control and management to prevent over-charging and over-discharging by monitoring voltage, current, temperature, etc., of the battery system 10, and may include, for example, a battery management system (BMS).

The battery management apparatus 1, which is an interface for receiving measurement values of the above-described various parameter values, may include a plurality of terminals and a circuit, etc., connected thereto to process input values. Further, the battery management apparatus 1 may control the switching unit 16, for example, on/off of a relay, a contactor, etc., and may be connected to the battery module 12 to monitor a state of each battery module 12.

The battery management apparatus 1 may receive temperature data, voltage data, and current data from the sensor unit 14 to obtain battery state information and diagnose a state of the battery.

The higher-level controller 20 may transmit a control signal for controlling the battery module 12 to the battery management apparatus 1. Thus, the battery management apparatus 1 may be controlled in terms of an operation thereof based on the control signal applied from the higher-level controller 20. Also, the battery module 12 may be a component included in an energy storage system (ESS). In this case, the higher-level controller 20 may be a control unit (BBMS) of a battery bank including the plurality of battery systems 10 or an ESS control unit for controlling the entire ESS including a plurality of banks. However, the battery system 10 is not limited to such a purpose.

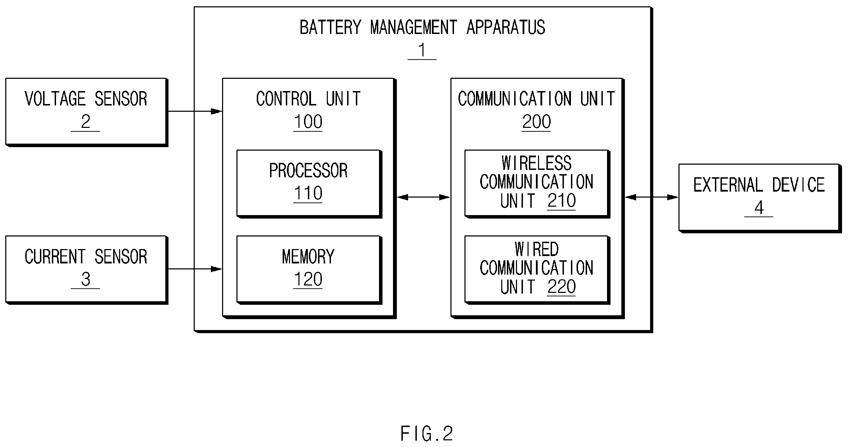

FIG. 2 is a block diagram showing a configuration of a battery management apparatus according to an embodiment.

Referring to FIG. 2, the battery management apparatus 1 according to an embodiment may include a control unit 100 including at least one processor 110 and a memory 120 and a communication unit 200, and may diagnose a battery by communicating with an external device 4 through the communication unit 200.

According to an embodiment, the external device 4 communicating with the battery management apparatus 1 may include a user terminal of a server device that transmits a diagnosis result of the battery management apparatus 1.

Specifically, when the external device 4 is a user terminal, the control unit 100 of the battery management apparatus 1 may transmit a diagnosis result of the battery to the user terminal to enable a user to check the diagnosis result. In this case, the user terminal may include, but not limited to, a personal computer (PC), a terminal, a portable telephone, a smart phone, a handheld device, a wearable device, etc.

When the external device 4 is a server device, the server device may be implemented with various computing devices such as workstations, clouds, data drives, data stations, etc. The server device may be implemented as one or more server devices physically or logically separated based on a function, a detailed configuration thereof, data, etc., and data may be transmitted and received through communication between server devices and the transmitted and received data may be processed.

The battery management apparatus 1 according to an embodiment may mean any electronic device including the processor 110 and the memory 120, and may be mounted on a vehicle to operate. Hereinbelow, each component of the battery management apparatus 1 may be described in detail.

The communication unit 200 may include a wireless communication unit 210 and a wired communication unit 220 to communicate with the external device 4. The communication unit 200 may transmit and receive a program for feature calculation, class classification, and lifetime estimation for a battery cell or various data, etc., to and from a separately provided external server.

The wireless communication unit 210 may include at least one of a short-range communication module or a long-range communication module.

The short-range communication module may communicate with the external device 4 adjacent to the battery management apparatus 1 by using a short-range communication method. Herein, the short-range communication module may use one communication method among Bluetooth, Bluetooth low energy (BLE), infrared data association (IrDA), Zigbee, WiFi, WiFi Direct, ultra-wideband (UWB), or near field communication (NFC).

The long-range wireless communication module may include a communication module performing various types of long-range communication, and may include a mobile communication module. The mobile communication unit may transmit and receive a radio signal to and from at least one of a base station and an external terminal over a mobile communication network. The long-range communication module may communicate with the external device 4 or other electronic devices, etc., through a nearby access point (AP). The AP may connect a local area network (LAN) to which the battery management apparatus 1 is connected to a wide area network (WAN) to which the communication server is connected. Thus, the battery management apparatus 1 may be connected to the communication server through the external device 4 and the WAN to communicate with each other.

The wired communication unit 220 may access the wired communication network and communicate with the external device 4 through the wired communication network. For example, the wired communication unit 220 may access the wired communication network through Ethernet (IEEE 802.3, technical standards), access the wired communication network through CAN communication, and transmit and receive data to and from the external devices 4 through the wired communication network.

The battery management apparatus 1 according to an embodiment may include an input/output interface (not shown). An interface may be provided to allow data to be transmitted and received by connecting an input device (not shown) such as a keyboard, a mouse, a touch panel, etc., an output device such as a display (not shown), etc., and the processor 110.

The memory 120 may store various information required for driving of the battery management apparatus 1. Specifically, the memory 120 may store an operating system and a program required for driving of the battery management apparatus 1 or store data required for driving of the battery management apparatus 1.

Specifically, the memory 120 may store various programs regarding feature calculation, class classification, and lifetime estimation of the battery cell. Moreover, the memory 120 may store various data such as a voltage, a current, feature data, etc., of each battery cell.

The memory 120 may also store the SOC and the SOH of the battery cell 13, estimated by the processor 110 and store a training model for machine learning.

The memory 120 may include a volatile memory 120 such as a static random access memory (S-RAM) and a dynamic random access memory (D-RAM) to temporarily memorize data. The memory 120 may also include a non-volatile memory 120 such as read only memory (ROM), erasable programmable read only memory (EPROM), and electrically erasable programmable read only memory (EEPROM), to store data for a long time.

The processor 110 may control in overall the battery management apparatus 1 by outputting a control signal. The processor 110 may include one CPU or graphics processing unit (GPU) or a plurality of CPUs or GPUs. In this case, the processor 110 may be implemented as an array of multiple logic gates, or may be implemented as a combination of the general-purpose microprocessor 110 and the memory 120 storing a program executable on the microprocessor 110.

The memory 120 and the processor 110 may be included in the control unit 100 that controls the above-described components to determine whether a defect occurs in a battery cell.

Specifically, the control unit 100 may receive a voltage value from the voltage sensor 2 and a current value from the current sensor, thereby deriving a voltage average of the battery cell 13. That is, the control unit 100 may derive a voltage average for each of a plurality of sections included in the battery data.

The plurality of sections may refer to sections in which charging/discharging is performed while different current values being maintained in a charging/discharging profile. The control unit 100 may derive a voltage average for each of the plurality of sections in which a current value is maintained in a specific range, and the control unit 100 may input some of voltage averages for the plurality of sections as an input value to a training model based on self-supervised learning.

Some of the voltage averages used as the input value to the training model by the control unit 100 may refer to one section set at random among the plurality of sections, and the plurality of sections may be used as the input value.

The control unit 100 may derive a voltage prediction value as an output value using the training model that may include a linear regression model. That is, the control unit 100 may derive a plurality of voltage prediction values as output values by using different linear regression models for the plurality of sections and compare the plurality of voltage prediction values with an actual value to detect whether the battery is defective.

Specifically, the control unit 100 may determine a difference between the voltage prediction values that are a plurality of output values and an actual voltage value measured actually as an error. The actual voltage value may mean a voltage average that is not used as an input value among the voltage averages of the plurality of sections. That is, the control unit 100 may use some of the voltage averages for the plurality of sections as input values and use other some as an actual value for determining an error from the output values.

The control unit 100 may sum errors for the plurality of sections to determine a diagnostic indicator of the battery cell 13. Thus, the control unit 100 may derive a diagnostic indicator for all battery cells 13 included in one battery pack and determine whether the battery cell 13 or the battery pack is defective.

As such, the battery management apparatus 1 according to an embodiment may diagnose whether a defect occurs in the battery cell 13 using the training model based on self-supervised learning, thereby providing a marvelous effect of improving the reliability of diagnosis even when defective data is insufficient.

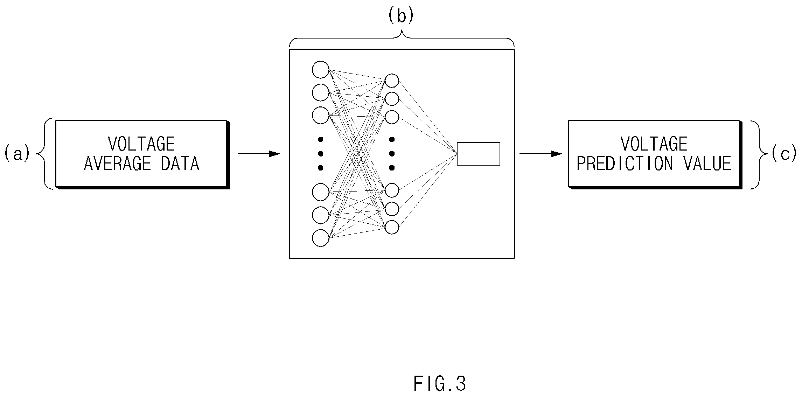

FIG. 3 shows an input value and an output value of a machine learning model used in a battery management apparatus according to an embodiment.

Referring to FIG. 3, the control unit 100 may train an artificial neural network (ANN) model b by using voltage average data for a plurality of sections as training data a and derive a voltage prediction value as output data c.

Herein, the voltage average data may be derived by the control unit 100 receiving a voltage of each cell through the sensor unit 14 and calculating an average of the received voltage data of each cell. The voltage average data used as the input value may mean partial data of the voltage average data of the plurality of sections.

When the control unit 100 includes an artificial intelligence (AI) dedicated processor 110 (e.g., an NPU) for training an artificial neural network (ANN) model b, the processor 110 may train an ANN by using weight data stored in the memory 120 as training data of a machine learning model.

Examples of a training algorithm may include supervised learning, unsupervised learning, semi-supervised learning, or reinforcement learning, but the battery management apparatus 1 according to an embodiment may determine whether the battery is defective based on self-supervised learning.

The ANN included in the machine learning model may include a plurality of neural network layers. Each of the plurality of neural network layers may have a plurality of weight values, and perform a neural network operation through an operation between an operation result of a previous layer and the plurality of weight values. The plurality of weight values of the plurality of neural network layers may be optimized by a training result of the AI model. For example, the plurality of weight values may be updated to reduce or minimize a loss value or a cost value obtained in the AI model during a training process.

Examples of the AI neural network may include, but not limited to, a deep neural network (DNN), e.g., a convolutional neural network (CNN), a DNN, a recurrent neural network (RNN), a restricted Boltzmann machine (RBM), a deep belief network (DBN), a bidirectional recurrent deep neural network (BRDNN), a deep Q-network, etc.

The control unit 100 may learn a correlation between voltage average data that is the training data a and a voltage prediction value that is the output data c, based on the selected AI model.

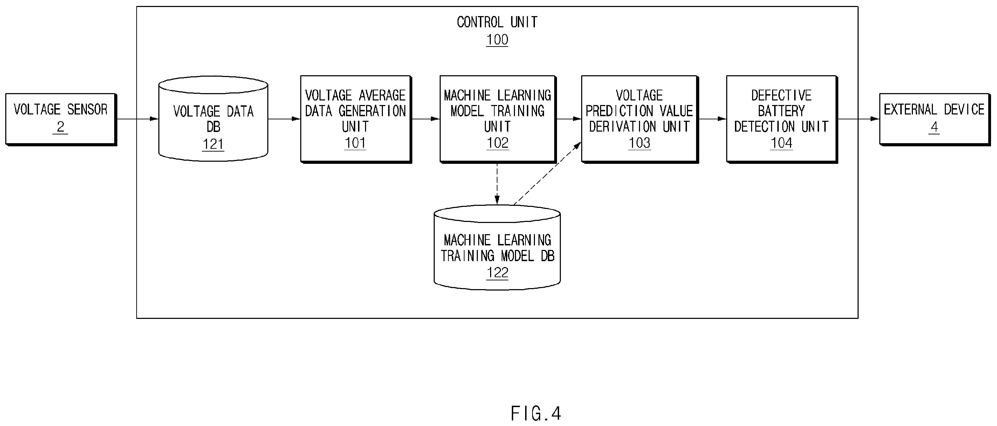

FIG. 4 is a schematic flowchart for a battery management apparatus according to an embodiment to detect a defective battery. Components 101 to 104 in FIG. 4 may be implemented in the form of a software block, and may be stored in the memory 120 and executed by the processor 110.

Referring to FIG. 4, the control unit 100 may obtain voltage data included in the battery data from the voltage sensor 2 and store the received voltage data of each battery cell 13 in a voltage data database (DB) 121.

Thereafter, a voltage average data generation unit 101 of the control unit 100 may generate average voltage data based on the voltage data stored in the voltage data DB 121. A method, performed by the control unit 100, of generating the voltage average data of the battery cell 13 may include generating voltage average data of each of all the battery cells 13 included in one battery pack or generating voltage average data in parallel for all battery packs.

The voltage average data generated by the control unit 100 may include not only a voltage average in a charging process, but also a voltage average in a discharging process. Hereinbelow, for convenience of a description, the voltage average data will be described as the voltage average in the charging process.

A machine learning model training unit 102 of the control unit 100 may train a model based on a preset hyper parameter and a selected feature. Specifically, the control unit 100 may learn a parameter of a model by using the selected feature to predict a voltage average.

The battery management apparatus 1 according to an embodiment may derive voltage prediction value data by applying the LMM to the voltage average data.

Herein, the LMM may mean a model that performs linear regression for each battery pack, and may derive voltage prediction value data by applying a plurality of linear regression models to the respective battery cells 13 included in one battery pack.

The control unit 100 may determine the voltage prediction value data obtained in the foregoing process as a target output value of the machine learning model, change the hyper parameter of the machine learning training model or add data to train the machine learning model, and store the trained machine learning model in a machine learning training model DB 122.

Thereafter, a voltage prediction value derivation unit 103 of the control unit 100 may determine an output value of the trained machine learning model as a voltage prediction value. Specifically, the control unit 100 may derive the voltage prediction value to use the same as data for comparison with the actual value.

Herein, the voltage prediction value may mean a plurality of voltage prediction values derived using, as an input value of the training model, some of a plurality of sections where a voltage is maintained in a specific range.

A defective battery detection unit 104 of the control unit 100 may compare an actual value of each section corresponding to the voltage prediction value with the voltage prediction value to calculate an error. Specifically, the control unit 100 may determine, as an error, a difference between the voltage prediction value derived as the output value and the actual value, and sum errors occurring in one battery cell 13 to derive a battery safety diagnostic indicator.

The control unit 100 may determine that the battery cell 13 having the derived diagnostic indicator exceeding a preset diagnosis criterion is defective. The diagnosis criterion may mean a value previously stored in the memory 120 according to physical and chemical characteristics of the battery.

The control unit 100 may then transmit information of the battery cell 13 determined as being a defective battery to the external device 4, such that a user or a manager of the battery may easily identify the information of the defective battery remotely.

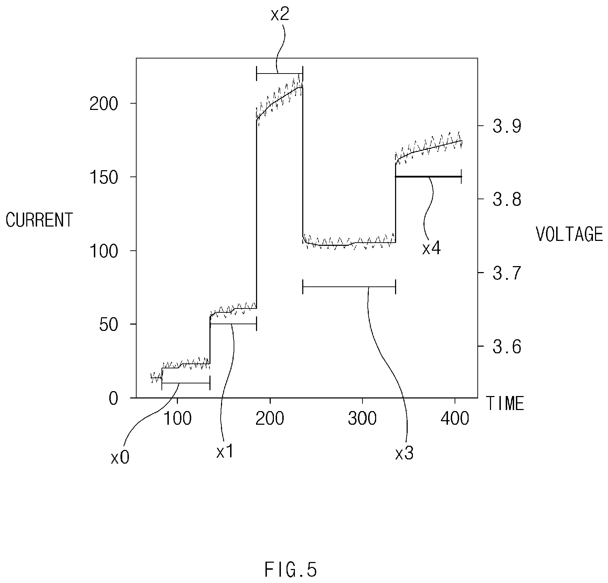

FIG. 5 shows a voltage average derived by a battery management apparatus according to an embodiment.

FIG. 5 shows a graph of a current and a voltage for a process of charging a battery over time in which an x axis means time.

That is, in a process of charging a battery, there may be five sections x0 to x4 in which charging is performed with current values in different specific ranges. The current values in the different specific ranges may mean a section in which current is gently maintained between 20 and 25 without being sharply changed, a section in which current is gently maintained about 60 without being sharply changed like at x1, a section in which current is gently maintained within 200 without being sharply changed like at x2, a section in which current is gently maintained within 110 without being sharply changed like at x3, or a section in which current is gently maintained within 150 without being sharply changed like at x4.

As such, the plurality of sections in which charging is performed with different current values may be derived differently according to a state of the battery and a control strategy of a charger, and the control unit 100 may determine the plurality of sections by differentiating a slope of the graph.

The control unit 100 may derive an average of sections in which charging is performed with different current values in a charging or discharging process. For example, the control unit 100 may determine, among the plurality of sections, a voltage average of a section x0 as 3.55, a voltage average of a section x1 as 3.62, a voltage average of a section x2 as 3.95, a voltage average of a section x3 as 3.73, and a voltage average of a section x4 as 3.83.

In this way, the control unit 100 may derive a voltage prediction value by using a voltage average as an input value of the training model and derive from a difference between a voltage prediction value and an actual value whether the battery is defective.

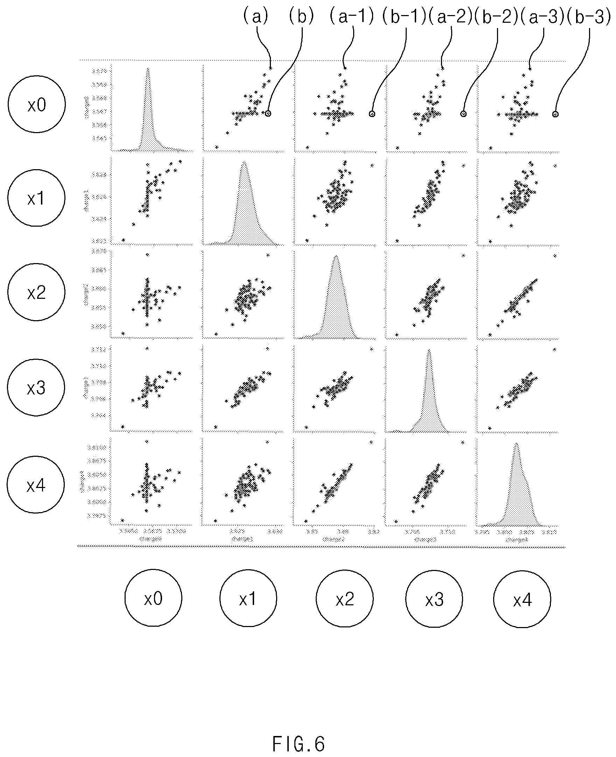

FIG. 6 shows a correlation between a normal battery cell and a defective battery cell, derived by a battery management apparatus according to an embodiment.

Referring to FIG. 6, an x axis and a y axis may mean a voltage average derived by the control unit 100. Specifically, dots expressed in FIG. 6 may mean the respective battery cells 13, and (a) may mean a voltage average of the section x1 along an x axis and a voltage average of the section x0 along a y axis. (a-1) may mean a voltage average of the section x2 along the x axis and a voltage average of the section x0 along the y axis, (a-2) may mean a voltage average of the section x3 along the x axis and the voltage average of the section x0 along the y axis, and (a-3) may mean a voltage average of the section x4 along the x axis and the voltage average of the section x0 along the y axis.

x0 and x1 to x4 show a globally linear correlation, and (a) to (a-3) may be determined to be included in a group of normal cells, corresponding to a linear correlation.

On the other hand, (b) to (b-3) may mean abnormal values out of a linear correlation and separate data points having values significantly out of a general pattern of a voltage average data set or exceptionally high or low values.

As the defective battery cell 13 shows a different behavior from the normal battery cell 13 in the voltage average data, the battery management apparatus 1 according to an embodiment may derive a diagnostic indicator using a machine learning method based on such characteristics and determine whether the battery is defective.

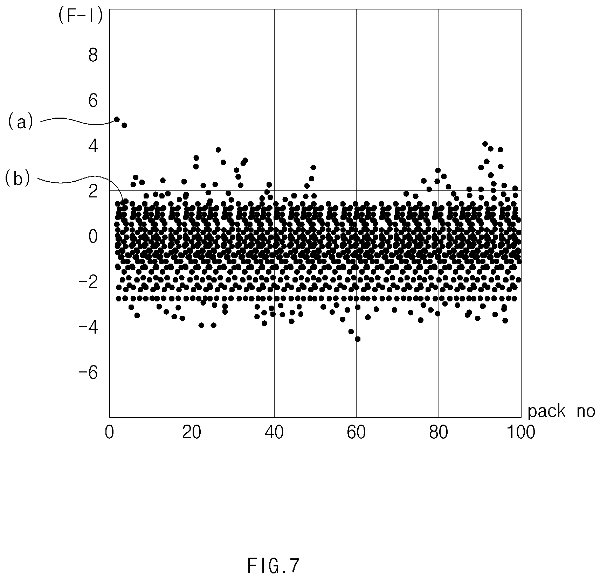

FIG. 7 is a graph showing a diagnostic indicator derived by a battery management apparatus according to an embodiment.

Referring to FIG. 7, the control unit 100 may derive a safety diagnostic indicator to determine whether the battery is defective. Herein, the diagnostic indicator may mean a sum of errors for a plurality of sections derived based on a training model.

That is, the control unit 100 may determine a difference between a voltage average (actual value) for a plurality of sections in which a voltage is maintained constant in a charging/discharging profile of the battery cell 13 and a voltage prediction value for the plurality of sections derived based on the training model, as an error for each of the plurality of sections.

For example, the control unit 100 may use an average of five sections in which a voltage is maintained constant as an actual value for a specific battery cell 13, and may use one of the five sections as an input value and determine differences between prediction values for the other four sections and the actual value as four errors.

Thereafter, the control unit 100 may determine a battery safety diagnostic indicator for the specific battery cell 13 by summing the determined four errors.

As such, the diagnostic indicator determined by the control unit 100 may be predefined by a battery designer such that an absolute value thereof has a specific meaning, or the battery cell 13 having an abnormal value may be determined as being defective based on a relative difference between diagnostic indicators. Hereinbelow, an embodiment to determine whether the battery is defective based on the relative difference between the diagnostic indicators will be described.

The control unit 100 may visualize a diagnostic indicator (final indicator (F-I)) with the diagnostic indicator as the y axis and a battery pack number as the x axis as in FIG. 7. Thus, the control unit 100 may display as many dots as the number of battery cells 13 included in each pack and derive a relative difference of diagnostic indicators based on a feature that normal battery cells 13 occupy a greater number than abnormal battery cells 13.

For the battery cell 13 a and the battery cell 13 b, as the battery cell 13 b is located in a crowded diagnostic indicator area between 0 and 2 and the battery cell 13 a is located in an area between 4 and 6 out of the crowded diagnostic indicator area, the control unit 100 may determine the battery cell 13 a as the defective battery cell 13.

The control unit 100 may also determine the battery cell 13 as the defective battery cell 13 when the diagnostic indicator of the specific battery cell 13 exceeds a preset reference value. For example, assuming that a diagnostic reference value stored in the memory 120 or input from the user is 4, the control unit 100 may determine the battery cell a as the defective battery cell 13 because the battery cell 13 a exceeds 4, and determine the battery cell 13 b as the normal battery cell 13 because the battery cell 13 b is less than 4.

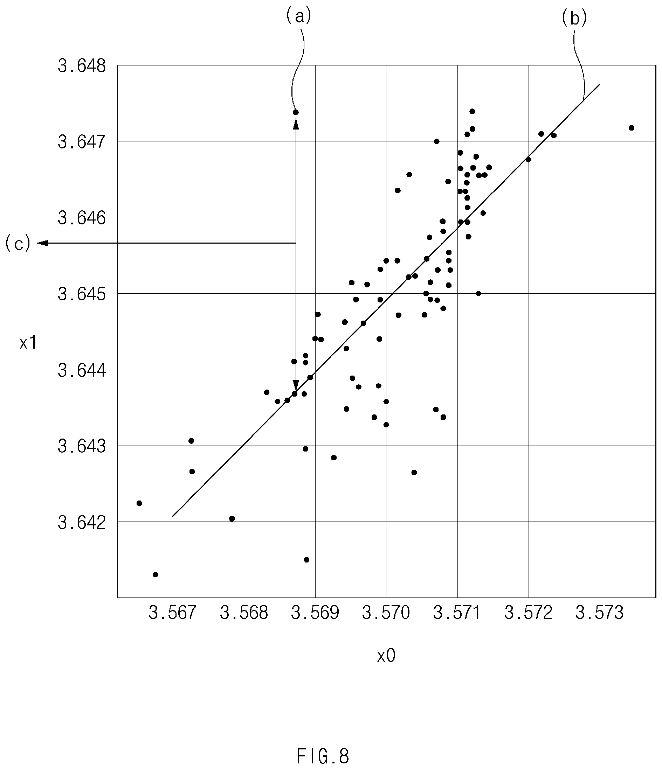

FIG. 8 shows a voltage prediction value and an actual value, derived from one battery pack, by a battery management apparatus according to an embodiment. FIG. 8 shows a process, performed by the control unit 100, of deriving an error for the plurality of battery cells 13 included in one battery pack.

Using the voltage average of the section x0 along the x axis and the voltage average of the section x1 along the y axis, the control unit 100 may derive values of the battery cells 13 included in the battery pack as shown in FIG. 8.

The control unit 100 may derive a voltage prediction value b using a voltage average for some sections as an input value for the training model based on self-supervised learning. Thereafter, the control unit 100 may determine a difference between a voltage average of each battery cell 13 like the battery cell 13 a and the voltage prediction value b as the error c.

In FIG. 8, as the error c between the battery cell 13 a and the voltage prediction value b is greater than those for the other battery cells 13, the error c may be determined as an abnormal value and the battery cell 13 a may be determined as the defective battery cell 13.

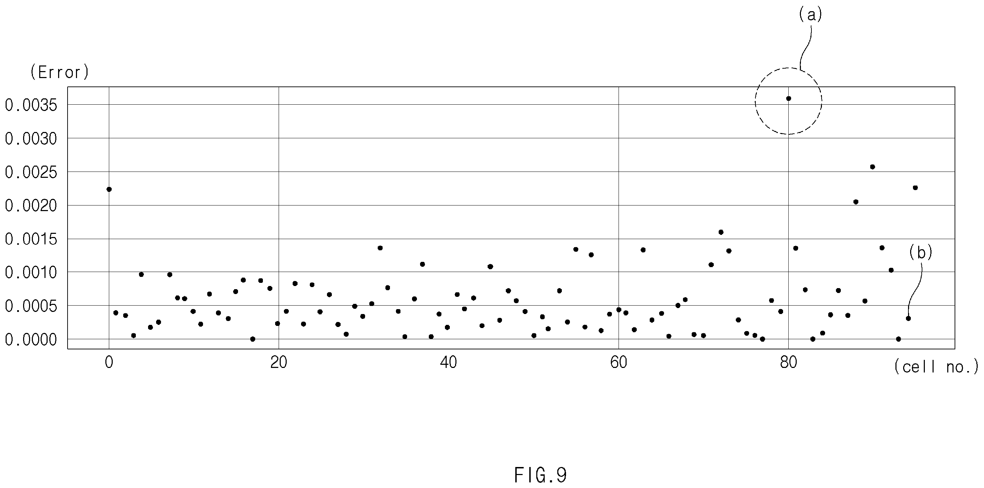

FIG. 9 shows an error derived from one battery pack by a battery management apparatus according to an embodiment.

Next, referring to FIG. 9, the control unit 100 may diagram an abnormal value of the battery cell 13 using a number of each battery cell 13 along the x axis and an error along the y axis.

Thus, the control unit 100 may determine the battery cell 13 #80 as the defective battery cell 13 as the error of the battery cell 13 #80 has a greater value than those of the other battery cells 13.

For the battery cell 13 a and the battery cell 13 b, as the battery cell 13 b is located in a crowded error area between 0 and 0.0015 and the battery cell 13 a is located in an area over 0.0035 out of the crowded error area, the control unit 100 may determine the battery cell 13 a as the defective battery cell 13.

The control unit 100 may also determine the battery cell 13 as the defective battery cell 13 when the error of the specific battery cell 13 exceeds a preset reference value. For example, assuming that an error reference value stored in the memory 120 or input from the user is 0.0020, the control unit 100 may determine the battery cell a as the defective battery cell 13 because the battery cell 13 a exceeds 0.0020, and determine the battery cell 13 b as the normal battery cell 13 because the battery cell 13 b is less than 0.0020.

As such, the battery management apparatus 1 according to an embodiment may determine whether the specific battery cell 13 is defective by directly using the error as well as the diagnostic indicator, thereby determining whether the battery is defective more variously and elaborately.

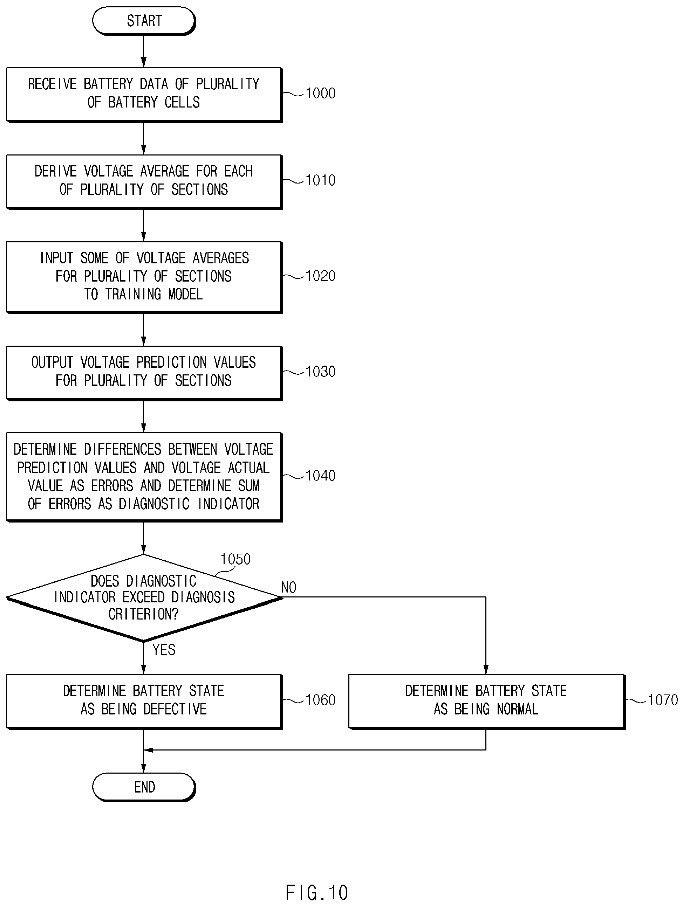

FIG. 10 is a control flowchart of a battery management method according to an embodiment.

Referring to FIG. 10, the control unit 100 may receive battery data of the plurality of battery cells 13 through the communication unit 200, in operation 1000. Thereafter, the control unit 100 may derive a voltage average for each of a plurality of sections that may mean sections in which a voltage is maintained in a specific range in a charging/discharging process.

The control unit 100 may input some of voltage averages for the plurality of sections into a training model in operation 1020 and output voltage prediction values for the plurality of sections in operation 1030.

Thereafter, the control unit 100 may determine differences between the voltage prediction values for the plurality of sections and a voltage actual value as errors and sum the errors for the sections to derive a diagnostic indicator, in operation 1040.

The control unit 100 may determine whether the diagnostic indicator exceeds a diagnosis criterion in operation 1050 and determine that a battery state is defective in operation 1060 when the diagnostic indicator exceeds a preset diagnosis criterion (Yes in operation 1050). When the diagnostic indicator is less than or equal to the preset diagnosis criterion (No in operation 1050), the control unit 100 may determine that the battery state is normal in operation 1070.

The diagnosis criterion may mean an average of the diagnostic indicators of the plurality of battery cells 13 and may mean a reference value obtained by applying an additional offset to the average.

As such, the battery management apparatus 1 according to an embodiment may define a battery safety diagnostic index and derive a diagnostic indicator based on machine learning, thereby diagnosing a cause for a defect more accurately.

Meanwhile, disclosed embodiments may be implemented in the form of a recording medium that stores an instruction executable by a computer. The instruction may be stored in the form of a program code, and, when executed by a processor, may generate a program module and perform operations according to disclosed embodiments. The recording medium may be implemented as a computer-readable recording medium.

The computer-readable recording medium may include any type of recording media that store an instruction interpretable by a computer. For example, the computer-readable recording medium may include ROM, RAM, a magnetic tape, a magnetic disk, flash memory, an optical data storage device, etc.

In addition, the computer-readable recording medium may be provided in the form of a non-transitory storage medium. Herein, the term 'non-transitory storage medium' simply means that the storage medium is a tangible device, and does not include a signal (e.g., an electromagnetic wave), but this term does not differentiate between where data is semi-permanently stored in the storage medium and where the data is temporarily stored in the storage medium. For example, the 'non-transitory storage medium' may include a buffer storing data temporarily.

According to an embodiment, a method according to various embodiments disclosed herein may be included and provided in a computer program product. The computer program product may be traded as a product between a seller and a buyer. The computer program product may be distributed in the form of a machine-readable recording medium (e.g., compact disc read only memory (CD-ROM)), or be distributed (e.g., downloaded or uploaded) online via an application store (e.g., PlayStore^{™}), or between two user devices (e.g., smart phones) directly. When distributed online, at least a part of the computer program product (e.g., a downloadable app) may be temporarily generated or at least temporarily stored in the machine-readable recording medium, such as memory of the manufacturer's server, a server of the application store, or a relay server.

Even though all components constituting an embodiment disclosed herein have been described above as being combined into one or operating in combination, the embodiments disclosed herein are not necessarily limited to the embodiment. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit disclosed herein is not limited by these embodiments. The protection scope of the technical spirit disclosed herein should be interpreted by the following claims, and all technical spirits within the same range should be understood to be included in the range of this document.

### List of Reference Numerals for Major Elements

1: Battery Management Apparatus
2: Voltage Sensor
3: Current Sensor
4: External Device
10: Battery System
12: Plurality of Battery Modules
13: Battery Cell
14: Sensor Unit
16: Switching Unit
20: Higher-Level Controller
100: Control Unit
110: Processor
120: Memory
200: Communication Unit
210: Wireless Communication Unit
220: Wired Communication Unit

## Claims

1. A battery management apparatus comprising:
a communication unit configured to receive battery data of a battery cell; and
a control unit configured to derive a voltage average for each of a plurality of sections included in the battery data, input some of voltage averages for the plurality of sections to a training model based on self-supervised learning, and detect whether the battery cell is defective by using voltage prediction values output by the training model.

2. The battery management apparatus of claim 1, wherein the control unit is further configured to determine, as the voltage average, an average of each section in which a voltage is maintained constant in a charging/discharging profile of the battery cell.

3. The battery management apparatus of claim 1, wherein the training model comprises a plurality of linear regression models comprising voltage averages remaining after excluding some from the voltage averages.

4. The battery management apparatus of claim 3, wherein the control unit is further configured to derive a plurality of output values by inputting some of the voltage averages to the plurality of linear regression models.

5. The battery management apparatus of claim 4, wherein the control unit is further configured to determine, as an error for each of the plurality of sections, a difference between the voltage prediction values that are the plurality of output values and an actual value that is a part of the voltage averages.

6. The battery management apparatus of claim 5, wherein the control unit is further configured to determine a diagnostic indicator of the battery cell by summing errors for the plurality of sections.

7. The battery management apparatus of claim 6, wherein the control unit is further configured to determine the battery cell as being defective based on that the diagnostic indicator exceeds a preset diagnosis criterion.

8. The battery management apparatus of claim 1, wherein the training model based on self-supervised learning comprises a linear mixed model (LMM) to detect whether the battery cell is defective.

9. A battery management method comprising:
receiving battery data of a battery cell;
deriving voltage averages for a plurality of sections included in the battery data;
inputting some of the voltage averages for the plurality of sections to a training model based on self-supervised learning; and
detecting whether the battery cell is defective by using voltage prediction values output by the training model.

10. The battery management method of claim 9, wherein the deriving of the voltage averages comprises deriving, as the voltage average, an average of each section in which a voltage is maintained constant in a charging/discharging profile of the battery cell.

11. The battery management method of claim 9, wherein the training model comprises a plurality of linear regression models comprising voltage averages remaining after excluding some from the voltage averages.

12. The battery management method of claim 11, further comprising deriving a plurality of output values by inputting some of the voltage averages to the plurality of linear regression models.

13. The battery management method of claim 12, further comprising determining, as an error for each of the plurality of sections, a difference between the voltage prediction values that are the plurality of output values and an actual value that is a part of the voltage averages.

14. The battery management method of claim 13, further comprising determining a diagnostic indicator of the battery cell by summing errors for the plurality of sections.

15. The battery management method of claim 14, wherein the detecting of whether the battery cell is defective comprises determining the battery cell as being defective based on that the diagnostic indicator exceeds a preset diagnosis criterion.

16. The battery management method of claim 9, wherein the training model based on self-supervised learning comprises a linear mixed model (LMM) to detect whether the battery cell is defective.
